# EUROPÄISCHE PATENTANMELDUNG

(11) **EP 2 999 315 A1**
(43) Veröffentlichungstag der Anmeldung: **23.03.2016**
(21) Anmeldenummer: 14185690.6
(22) Anmeldetag: 22.09.2014
(51) Int. Cl.: H05K 1/02, H05K 3/30, H05K 7/14, H05K 9/00, H01R 4/30, H01R 12/52, H01R 12/58

(54) **Befestigung einer Leiterplatte an einem Trägerelement**

(71) Anmelder: Siemens Aktiengesellschaft, 80333 München (DE)
(72) Erfinder: Seebahn, Björn, 91054 Erlangen (DE)

(57) **Zusammenfassung**

Die Erfindung betrifft eine Vorrichtung zur Befestigung einer Leiterplatte (1) an einem Trägerelement (2) mittels eines Befestigungselements (3), insbesondere mittels einer Schraube (3). Für eine sichere sowohl mechanische als auch elektrische Verbindung der Leiterplatte mit dem Trägerelement wird vorgeschlagen, dass die Leiterplatte (1) eine metallisierte Leiterplattenbohrung (4) aufweist, durch die das Befestigungselement (3) hindurchführbar ist, wobei das Trägerelement (2) eine Bohrung (6), insbesondere eine Gewindebohrung zur Aufnahme der Schraube (3) aufweist und wobei die Vorrichtung weiter einen Spreizeinsatz (8) umfasst, der zur Ausfüllung eines Zwischenraums zwischen der Schraube (3) und der Leiterplattenbohrung (4) vorgesehen ist.

## Beschreibung

Die Erfindung betrifft eine Vorrichtung zur Befestigung einer Leiterplatte an einem Trägerelement mittels eines Befestigungselements.

Eine derartige Vorrichtung kommt insbesondere als Schraubverbindung beispielsweise im Bereich der Leiterplattentechnik zum Einsatz. Hierbei besteht häufig die Notwendigkeit, eine Leiterplatte auf ein Trägerelement, beispielsweise einem Gehäuseteil oder einem Kühlkörper sowohl mechanisch als auch elektrisch sicher zu verbinden. Die elektrische Verbindung dient dabei häufig als sogenanntes Bezugspotenzial. Neben der mechanischen Befestigung ist auch ein klar definiertes elektrisches Potenzial, beispielsweise ein sogenanntes Erdpotenzial notwendig. Bisherige Lösungen verwenden hierzu in der Regel eine Schraube, einen Federring und eine Unterlegscheibe, wobei die Schraube durch eine Bohrung in der Leiterplatte geführt und dann im Trägerelement durch Verschrauben kontaktiert und befestigt wird.

Der Erfindung liegt die Aufgabe zu Grunde, eine Vorrichtung zur Befestigung einer Leiterplatte an einem Trägerelement mittels eines Befestigungselements anzugeben, die eine sowohl mechanisch als auch elektrisch sichere und stabile Verbindung der Leiterplatte mit dem Trägerelement ermöglicht.

Diese Aufgabe wird durch eine Vorrichtung zur Befestigung einer Leiterplatte an einem Trägerelement mittels eines Befestigungselements, insbesondere mittels einer Schraube oder mittels einer Niete gelöst, wobei die Leiterplatte eine meta-llisierte Leiterplattenbohrung, insbesondere eine Gewindebohrung aufweist, durch die das Befestigungselement hindurchführbar ist, wobei das Trägerelement eine Bohrung zur Aufnahme des Befestigungselements aufweist und wobei die Vorrichtung weiter einen Spreizeinsatz umfasst, der zur Ausfüllung eines Zwischenraums zwischen dem Befestigungselement und der Leiterplattenbohrung vorgesehen ist.

Der Erfindung liegt die Erkenntnis zugrunde, dass bei konventionellen Verbindungen z.B. mittels einer Schraube als Befestigungselement, die durch eine Bohrung in der Leiterplatte geführt wird, die Bohrung größer sein muss, als der Schaft der Schraube, so dass in der Regel für die Kontaktierung der Schraube mit der Kontaktfläche der Leiterplatte lediglich der Schraubenkopf verwendet wird, der dann über einen Federring und eine Unterlegscheibe gedrückt wird. Im Gegensatz hierzu wird bei der vorliegenden Erfindung die Kontaktfläche von Schraube und Leiterplatte dadurch vergrößert, dass die Vorrichtung einen speziellen Spreizeinsatz umfasst, der in die Gewindebohrung einführbar ist und so den Zwischenraum zwischen der Schraube und der Leiterplattenbohrung ausfüllt. Dieser Spreizeinsatz wirkt mit der metallisierten Leiterplattenbohrung zusammen, so dass hierdurch eine großflächige, sowohl mechanisch als auch elektrisch sichere Verbindung entsteht. Eine derartige Verbindung ist auch dauerhaft gegen Vibrationen und Alterung beständig.

Vorteilhafte Ausgestaltungsformen sind in den Unteransprüchen enthalten.

So wird bei einer vorteilhaften Ausgestaltungsform der Spreizeinsatz aus einer Hülse gebildet, die zumindest teilweise konisch geformt ist. Hierdurch wird der Spreizeinsatz in der metallisierten Leiterplattenbohrung sicher fixiert und gleichzeitig ein dauerhafter elektrischer Kontakt hergestellt.

Bei einer weiteren Ausgestaltungsform weist der Spreizeinsatz einen Federring auf. Dieser Federring bewirkt eine gezielte Verformung des Spreizeinsatzes im Bereich der metallisierten Leiterplattenbohrung, was sowohl die mechanische als auch die elektrische Verbindung weiter verbessert.

Bei einer weiteren Ausgestaltungsform besteht der Spreizeinsatz aus einem dehnbaren und elektrisch leitfähigen Material. Hierdurch kann eine durchgängige elektrische Verbindung zwischen der Leiterplatte und dem Trägerelement bewirkt werden.

Bei einer weiteren Ausgestaltungsform besteht der Spreizeinsatz aus einem metallisierten Kunststoffmaterial, welches auf einfache Weise kostengünstig, z.B. aus metallisiertem PVC, herstellbar ist.

Bei einer weiteren Ausgestaltungsform umfasst die Metallisierung der Leiterplatte im Bereich der Leiterplattenbohrung einen Metallring und/oder eine Metallisierung im Bereich der Leiterplattenbohrung.

Im Folgenden wird die Erfindung anhand der in den Figuren dargestellten Ausführungsbeispiele näher beschrieben und erläutert.

Es zeigen:
- FIG 1: eine Vorrichtung zur Befestigung einer Leiterplatte an einem Trägerelement mittels einer Schraube und
- FIG 2-5: jeweils Ausführungsbeispiele eines Spreizeinsatzes zur Befestigung einer Leiterplatte an einem Trägerelement.

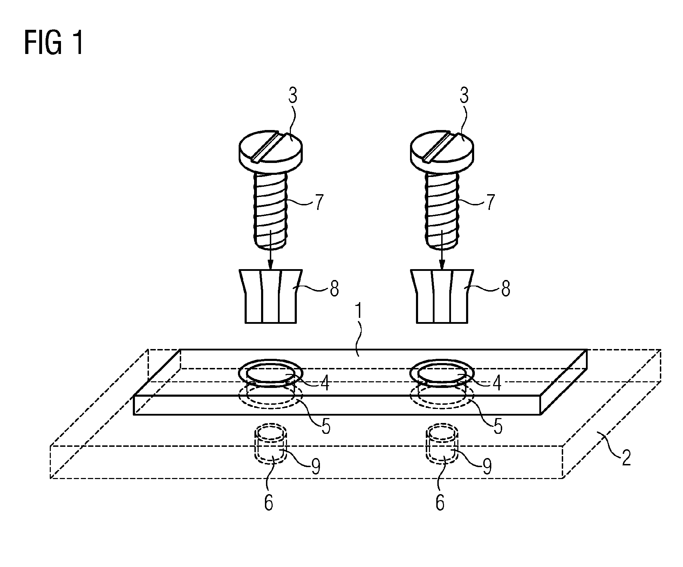

Figur 1 zeigt eine Vorrichtung zur Befestigung einer Leiterplatte 1 an einem Trägerelement 2 mittels einer Schraube 3. Die Leiterplatte weist Leiterplattenbohrungen 4 auf, die vorzugsweise mit Kupfer metallisiert ist. In Figur 1 ist diese Metallisierung mit Kupfer mit dem Bezugszeichen 5 versehen. Im Bereich der Leiterplattenbohrung 4 befindet sich im Trägerelement 2, welcher beispielsweise ein Gehäuse oder ein Kühlkörper ist, eine Gewindebohrung 6. Die Vorrichtung zur Befestigung der Leiterplatte 1 umfasst weiter eine Befestigungsschraube 3, die einen Schraubenschaft 7 mit einem Außengewinde aufweist, sowie einen Spreizeinsatz 8.

Zur Befestigung der Leiterplatte 1 auf dem Trägerelement 2 wird der Spreizeinsatz 8 in die Leiterplattenbohrung 4 eingeführt. Durch den in der Leiterplatte 1 eingeführten Spreizeinsatz 8 wird dann im nächsten Schritt die Befestigungsschraube 3 gesteckt, so dass das Außengewinde 7 der Befestigungsschraube 3 in Eingriff mit dem mit einem Innengewinde versehenen Gewindeloch 6 des Trägerelements 2 kommt. Die Befestigungsschraube 3 wird in gewohnter Weise angezogen. Dabei spreizt sich der Spreizeinsatz 8 in der metallisierten Leiterplattenbohrung 4 fest, wodurch sich eine sichere elektrische und mechanische Verbindung zwischen der Leiterplatte und dem Trägerelement, z.B. zur Herstellung eines Erdpotenzials, ergibt. Die Vergrößerung der Kontaktfläche von Trägerelement 2, Schraube 3 und Leiterplatte 1 führt schließlich zu einer Verringerung der Impedanz am Übergang der Befestigungsstelle. Diese Verringerung der Impedanzen ist insbesondere für hochfrequente Störströme relevant. Darüber hinaus ermöglicht die in Figur 1 dargestellte Befestigungsvorrichtung der Leiterplatte 1 eine selbständige Positionierung der Schraubverbindung, die ebenfalls eine gute Anpassung an Fertigungstoleranzen ermöglicht. Darüber hinaus wird auch die mechanische Belastbarkeit aufgrund der Vergrößerung der Zugefestigkeit der mechanischen Verbindung mittels des Spreizeinsatzes 8 erhöht.

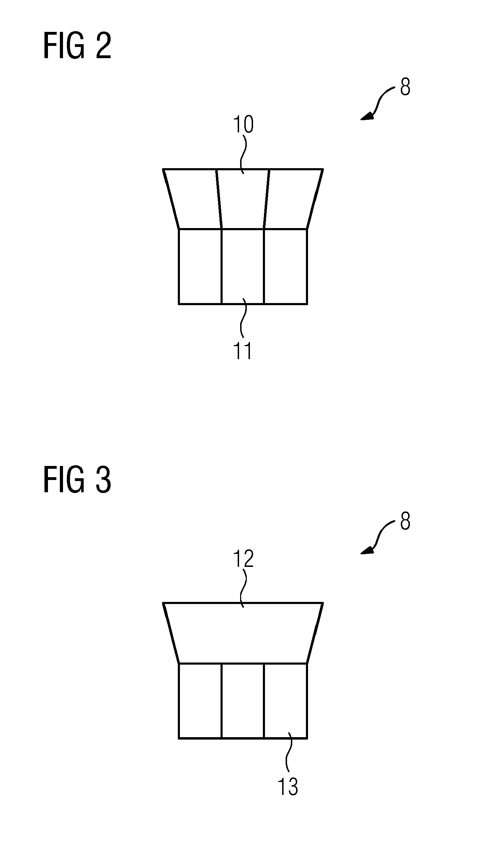

Figuren 2 bis 5 zeigen jeweils Ausführungsbeispiele eines Spreizeinsatzes 8 zur Befestigung einer Leiterplatte an einem Trägerelement, wie dies im Zusammenhang mit Figur 1 gezeigt und erläutert ist.

Der in Figur 2 dargestellte Spreizeinsatz 8 besteht aus metallisch leitfähigem Metall, wobei der Spreizeinsatz einen oberen Teilbereich 10 sowie einen unteren Teilbereich 11 aufweist. Der untere Teilbereich ist dabei im Wesentlichen zylindrisch ausgebildet, während der obere Teilbereich 10 eine konische Formgestaltung aufweist. Durch die spezielle Formgestaltung wird eine gezielte Spreizwirkung im Zusammenwirken mit der metallisierten Leiterplattenbohrung erzielt.

Figur 3 zeigt ein weiteres Ausführungsbeispiel eines Spreizeinsatzes 8. Auch bei dem in Figur 3 dargestellten Ausführungsbeispiel besteht der Spreizeinsatz aus einem oberen Teil 12, welches konisch ausgebildet ist und einem unteren Teil 13, welches zylindrisch ausgebildet ist. Im Gegensatz in dem in Figur 2 dargestellten Ausführungsbeispiel ist jedoch lediglich der untere Bereich 13 des Spreizeinsatzes 8 aus einzelnen abgewinkelten Teilflächen gestaltet.

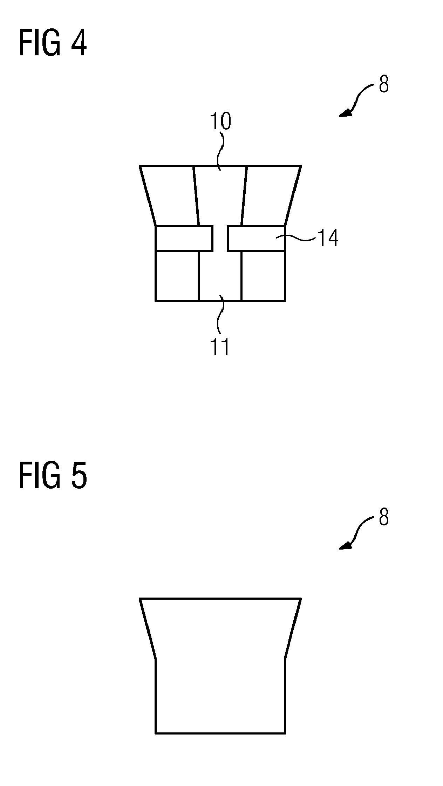

Figur 4 zeigt nochmals eine Abwandlung eines Spreizeinsatzes 8. Auch dieser Spreizeinsatz weist einen oberen Teilbereich 10 sowie einen unteren Teilbereich 11 auf, wie dies bereits im Zusammenhang mit Figur 2 dargestellt und erläutert ist. Zusätzlich umfasst der Spreizeinsatz 8 in Figur 4 einen Federring 14, der eine zusätzliche Stabilisierung und Fixierung des Spreizeinsatzes 8 bewirkt, wenn dieser in der Leiterplatte eingesetzt mit dem Trägerelement verschraubt ist, wie dies in Figur 1 gezeigt ist.

Figur 5 zeigt eine nochmalige Abwandlung eines Spreizelements, welches ebenfalls aus einem oberen und einem unteren Teilelement besteht. Im Gegensatz zu den in den Figuren 2 bis 4 dargestellten Ausführungsbeispielen besteht das in Figur 5 dargestellte Spreizelement 8 aus einem dehnbaren Material, beispielsweise aus einem metallisierten Kunststoff, insbesondere PVC oder Gummi.

Zusammenfassend betrifft die Erfindung eine Vorrichtung zur Befestigung einer Leiterplatte 1 an einem Trägerelement 2 mittels eines Befestigungselements 3, insbesondere mittels einer Schraube 3. Für eine sichere sowohl mechanische als auch elektrische Verbindung der Leiterplatte mit dem Trägerelement wird vorgeschlagen, dass die Leiterplatte 1 eine metallisierte Leiterplattenbohrung 4 aufweist, durch die das Befestigungselement 3, insbesondere die Schraube 3 hindurchführbar ist, wobei das Trägerelement 2 eine Bohrung 6, insbesondere eine Gewindebohrung zur Aufnahme der Schraube 3 aufweist, wobei die Vorrichtung weiter einen Spreizeinsatz 8 umfasst, der zur Ausfüllung eines Zwischenraums zwischen der Schraube 3 und der Leiterplattenbohrung 4 vorgesehen ist.

## Patentansprüche

1. Vorrichtung zur Befestigung einer Leiterplatte (1) an einem Trägerelement (2) mittels eines Befestigungselements (3), insbesondere mittels einer Schraube oder mittels einer Niete, wobei die Leiterplatte (1) eine metallisierte Leiterplattenbohrung (4), insbesondere eine Gewindebohrung aufweist, durch die das Befestigungselement (3) hindurchführbar ist, wobei das Trägerelement (2) eine Bohrung (6) zur Aufnahme des Befestigungselements (3) aufweist und wobei die Vorrichtung weiter einen Spreizeinsatz (8) umfasst, der zur Ausfüllung eines Zwischenraums zwischen dem Befestigungselement (3) und der Leiterplattenbohrung (4) vorgesehen ist.

2. Vorrichtung nach Anspruch 1, wobei der Spreizeinsatz (8) aus einer Hülse gebildet wird, die zumindest teilweise konisch geformt ist.

3. Vorrichtung nach einem der Ansprüche 1 oder 2, wobei der Spreizeinsatz (8) einen Federring (14) aufweist.

4. Vorrichtung nach einem der Ansprüche 1 bis 3, wobei der Spreizeinsatz (8) aus einem dehnbaren und elektrisch leitfähigen Material besteht.

5. Vorrichtung nach einem der Ansprüche 1 bis 4, wobei der Spreizeinsatz (8) aus einem metallisierten Kunststoffmaterial besteht.

6. Vorrichtung nach einem der Ansprüche 1 bis 5, wobei die Metallisierung der Leiterplatte (1) im Bereich der Leiterplattenbohrung (5) einen Metallring und/oder eine Metallisierung im Bereich der Leiterplattenbohrung umfasst.

7. Vorrichtung nach einem der Ansprüche 1 bis 6, wobei das Spreizelement (8) einen oberen Teilbereich (10, 12) und einen unteren Teilbereich (11, 13) aufweist, wobei der obere Teilbereich (10, 12) konisch und der untere Teilbereich (11, 13) zylindrisch ausgebildet sind.

8. Anordnung, insbesondere Schaltungsanordnung mit mindestens einer Vorrichtung nach einem der Ansprüche 1 bis 7 und mit mindestens einer Leiterplatte (1) und mit mindestens einem Trägerelement (2), wobei die Leiterplatte (1) eine metallisierte Leiterplattenbohrung (4), insbesondere eine Gewindebohrung aufweist, durch die das Befestigungselement (3) hindurchgeführt ist, wobei das Trägerelement (2) eine Bohrung (6) zur Aufnahme des Befestigungselements (3) aufweist und wobei der Spreizeinsatz (8) zur Ausfüllung eines Zwischenraums zwischen dem Befestigungselement (3) und der Leiterplattenbohrung (4) vorgesehen ist.

9. Anordnung nach Anspruch 8, wobei das Trägerelement als Kühlkörper ausgebildet ist.
